# FASCICULE DE BREVET EUROPEEN

(11) **EP 0 910 097 B1**
(45) Date de publication et mention de la délivrance du brevet: **17.01.2001**
(21) Numéro de dépôt: 98402556.9
(22) Date de dépôt: 14.10.1998
(51) Int. Cl.: G11C 29/00, G11C 16/06

(54) **Circuit intégré à mémoire comprenant un circuit interne de génération d'une haute tension de programmation**
Integrierte Speicherschaltung mit einer Schaltung zur Erzeugung einer hohen Programmierspannung
Integrated memory circuit including an internal high programming voltage generation circuit

(30) Priorité: 15.10.1997 FR 9712871
(43) Date de publication de la demande: 21.04.1999
(73) Titulaire: STMicroelectronics SA, 94250 Gentilly Cedex (FR)
(72) Inventeur: Chehadi, Mohamad, 94230 Cachan (FR); Naura, David, c/o Cabinet Ballot-Schmit, 94230 Cachan (FR)
(74) Mandataire: Ballot, Paul

(56) Documents cités:
- US-A- 5 109 257
- US-A- 5 363 335
- US-A- 5 379 260
- US-A- 5 544 123
- CEMEA R ET AL: "TA 7.4: A 34MB 3.3V SERIAL FLASH EEPROM FOR SOLID-STATE DISK APPLICATIONS" IEEE INTERNATIONAL SOLID STATE CIRCUITS CONFERENCE, vol. 38, 1 février 1995, page 126/127, 350 XP000557578

## Description

La présente invention concerne un circuit intégré à mémoire, comprenant un circuit interne de génération de haute tension pour la programmation et/ou l'effacement de cellules de la mémoire.

L'évolution de la technologie conduit en particulier à la baisse de la tension d'alimentation logique appliquée aux circuits intégrés, dans le but de réduire toujours plus la consommation. On peut ainsi trouver sur le marché actuel, des circuits logiques alimentés en 2 à 3 volts et on cherche à descendre à 1 volts.

Cependant, ce faible niveau d'alimentation logique n'est pas sans conséquences sur les performances de certains circuits. Notamment, certains circuits intégrés à mémoire comportent un circuit interne de génération de haute tension de programmation comme en particulier, les circuits intégrés à mémoire de type EEPROM. Ce circuit de génération de haute tension de programmation est particulièrement sensible au niveau de la tension d'alimentation logique qu'elle reçoit en entrée. D'une part, le niveau de la haute tension de programmation générée en sortie est affecté. Avec une tension d'alimentation logique plus basse, le niveau de la haute tension de programmation générée est plus faible. Ceci est gênant pour la programmation ou l'effacement des cellules mémoires. En effet avec une haute tension de programmation peu élevée (par exemple, V_{PP} = 9 volts avec une alimentation logique V_{CC} = 2 volts contre V_{PP} = 15 à 17 volts avec une alimentation logique de V_{CC} = 5 volts), la quantité de charges que l'on va pouvoir transférer de ou sous la grille est aussi plus faible. La cellule mémoire programmée a alors une plus grande sensibilité à la perte de charges (fuites, durée de rétention de donnée affectée). La cellule mémoire donne aussi un courant de lecture plus faible. L'accès en lecture est donc plus lent. En outre, le temps d'application de la haute tension V_{PP} aux cellules à programmer devra être plus long. Ceci augmente de manière sensible le temps nécessaire aux tests du circuit intégré ainsi que le temps nécessaire à l'initialisation du circuit intégré (configuration client avec programmation de données en mémoire). Enfin, le fait d'appliquer une tension d'alimentation logique V_{CC} plus faible en entrée entraîne que la fréquence d'oscillation du générateur de haute tension de programmation est aussi plus faible. On se retrouve alors en sortie de circuit de génération de haute tension de programmation V_{PP} avec une impédance de sortie plus élevée (sortance plus faible). Il n'est alors plus possible d'appliquer cette haute tension de programmation V_{PP} à toutes les cellules du plan mémoire, d'un quart de plan ou même d'une page en même temps : on aurait une charge (capacitive) en sortie trop élevée par rapport à cette sortance, ce qui ralentirait la montée de la haute tension. On ne peut donc pas envisager de faire des accès à tout le plan mémoire en écriture ou effacement ni même-en mode page ou en écriture quart de plan. On peut seulement envisager des accès en mode "byte", c'est à dire mot par mot. On comprend que l'on augmente alors sérieusement les temps de programmation et/ou d'effacement, ce qui affecte directement le temps de test et donc le coût final du circuit intégré. En outre, il ne permet pas d'offrir une grande souplesse d'accès aux utilisateurs des circuits intégrés, puisque seul le mode "byte" est possible, les modes "globaux" étant à proscrire.

L'invention a pour objet de remédier à ces problèmes techniques.

Dans l'invention, on a eu l'idée de prévoir un deuxième plot d'alimentation logique sur le circuit intégré, permettant d'alimenter en direct, par une autre source d'alimentation logique externe, le circuit de génération interne de la haute tension. Cette source fournit une tension d'alimentation logique spécifique, de niveau supérieur au niveau de la tension d'alimentation logique principale. Ce niveau spécifique peut en pratique être pris dans la plage admissible de valeurs des circuits alimentés en 5 volts, c'est à dire entre 3 et 7 volts en pratique. Le reste du circuit est alimenté par la tension d'alimentation logique principale (1 à 3 volts).

Une telle solution permet de continuer à utiliser tous les modes d'accès à la mémoire comme le mode page (ou l'écriture totale du plan mémoire ...), modes qui permettent de gagner beaucoup de temps. Ceci est particulièrement avantageux en modes de test et de configuration client : on gagne du temps et les cellules sont mieux programmées, c'est à dire avec une quantité de charges suffisante sous la grille pour réduire la sensibilité des cellules aux fuites (pertes de charges). Dans un exemple numérique pour une mémoire de l'état de la technique alimentée exclusivement sous 2 volts, l'effacement global de la mémoire devant alors se faire octet par octet, cette opération prend 24000 ms pour une mémoire de capacité 64 Kilo-octets. Avec cette même mémoire, mais alimentée selon l'invention avec une alimentation logique spécifique de 5 volts pour la génération de la haute tension et une alimentation logique principale de 2 volts pour le reste du circuit intégré, on peut pratiquer un effacement global de la mémoire, cette opération ne prenant alors que 3 ms. Cet exemple numérique simple montre bien tout l'intérêt de l'invention.

En plus, le fait d'utiliser une tension d'alimentation logique de niveau plus élevé pour la circuiterie interne de génération de haute tension est pratiquement sans incidence sur la consommation totale du circuit. En effet, dans un circuit mémoire, ce qui consomme le plus, c'est la circuiterie interne de lecture et dans l'invention, celle-ci reste alimentée par la broche d'alimentation logique principale. Le circuit de génération de haute tension lui ne consomme pratiquement pas puisque la tension d'alimentation logique ne lui sert pratiquement qu'à commuter des grilles de transistors. On a ainsi un avantage certain comparé à des solutions de l'état de la technique, qui, pour améliorer les performances en programmation des circuits alimentés sous faible tension d'alimentation, utilisent en interne des étages de bootstraps, très consommateurs en courant.

En pratique, l'utilisation d'un circuit intégré à basse tension d'alimentation logique (inférieure à cinq volts) avec une alimentation spécifique pour la circuiterie interne de génération de la haute tension va dépendre du nombre de broches disponibles sur le boîtier et de l'application visée. Ainsi, dans certains cas le plot d'alimentation spécifique est prévu sur la puce de circuit intégré, mais lorsque la puce est assemblée dans un boîtier, ce plot spécifique est raccordé à la broche d'alimentation logique principale. On ne peut pas alors appliquer le niveau d'alimentation spécifique que lorsque la puce n'est pas encore assemblée, au moyen d'une carte à pointes, notamment lors du test sur plaquettes (wafer test). En effet, on ne peut pas appliquer la tension d'alimentation spécifique (entre 3 et 7 volts) sur la broche d'alimentation principale, car la technologie "basse-tension", notamment au niveau de certaines entrées, ne supporterait pas un tel niveau.

Dans d'autres cas, le plot est raccordé à une broche spécifique du boîtier. On peut alors appliquer la tension d'alimentation spécifique non seulement par le biais de la carte à pointes sur la puce, mais aussi après assemblage de la puce, par la broche spécifique. On peut alors utiliser cette tension spécifique non seulement en test des plaquettes mais aussi en test final du circuit intégré en boîtier. Dans ce cas, on peut même envisager d'utiliser cette tension spécifique dans l'application, c'est à dire dans la phase de configuration client pour la programmation de données d'initialisation en mémoire selon les spécifications du client et en mode applicatif. Si on n'utilise pas ce niveau d'alimentation spécifique dans l'application, on appliquera la tension d'alimentation logique principale sur cette broche. Dans ce cas, on notera que la configuration client se fera aussi sous tension d'alimentation logique principale.

Telle que caractérisée, l'invention concerne donc un circuit intégré à mémoire comprenant un circuit interne de génération d'une haute tension de programmation et comportant un premier plot destiné à recevoir une tension d'alimentation logique principale inférieure à cinq volts. Selon l'invention, le circuit intégré comprend un deuxième plot d'alimentation spécifique pour alimenter ledit circuit de génération de haute tension, permettant l'application d'une tension d'alimentation logique spécifique de niveau de tension supérieur à celui de la tension d'alimentation logique principale.

L'invention concerne aussi l'utilisation d'un circuit intégré selon la revendication 1.

D'autres caractéristiques et avantages de l'invention sont présentés dans la description suivante, faite à titre indicatif et non limitatif de l'invention, en référence aux dessins annexés dans lesquels :
- la figure 1 représente un schéma-bloc d'un circuit intégré selon l'invention, dans une application à un circuit intégré à mémoire à accès série ;
- la figure 2 montre un mode de réalisation des connexions des plots avec les broches du boîtier et
- la figure 3 montre un autre mode de réalisation de ces connexions.

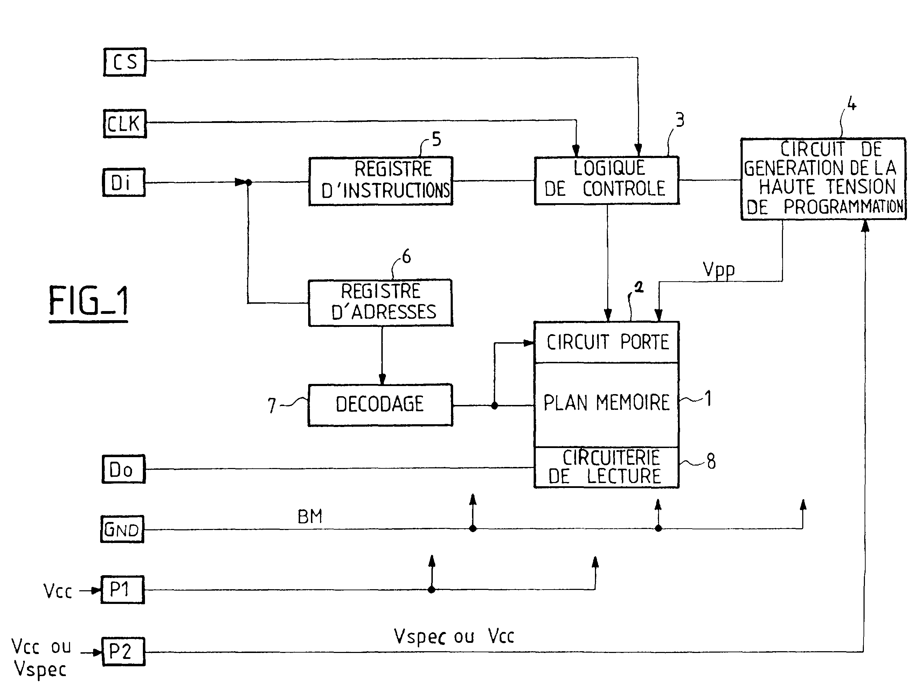

La figure 1 représente un exemple de circuit intégré à mémoire dans lequel l'invention a été mise en oeuvre. Dans cet exemple, on a choisi de représenter de manière simplifiée une mémoire du type à accès série. Il va de soi que l'invention s'applique à tout type de circuit intégré à mémoire, à accès série ou parallèle et comprenant un circuit interne de génération de haute tension de programmation.

De manière classique, le circuit intégré comprend un plan mémoire 1 associé à un circuit porte 2 commandé par un circuit logique de contrôle 3 et recevant le cas échéant en mode d'écriture (programmation ou effacement) une haute tension notée V_{PP}, générée par un circuit de génération interne 4 de haute tension (pompe de charges). Le circuit intégré comprend en outre des registres d'entrée connectés à un plot d'entrée série de données, Di ("data in"). Ces registres d'entrée sont le registre d'instruction 5 qui commande le circuit logique de contrôle et le registre d'adresses 6 associé au circuit de décodage 7 qui contrôle l'accès au plan mémoire. Enfin un circuit de lecture 8 comprenant en particulier des amplificateurs de lecture permet de transmettre les données lues en mémoire vers le plot de sortie série de donnée, noté Do (Data out). Le circuit intégré comprend aussi deux plots pour recevoir un signal de sélection du circuit CS et un signal d'horloge CLK.

Tous ces circuits doivent être alimentés. Dans l'invention, ces circuits sont tous reliés au bus de masse BM qui est connecté au plot GND. Et, à l'exception du circuit de génération de la haute tension, ils sont tous reliés au bus qui véhicule la tension d'alimentation logique principale Vcc. Cette tension d'alimentation logique principale Vcc est appliquée sur un plot d'alimentation P1 du circuit intégré. Le circuit de génération de la haute tension de programmation est lui, selon l'invention, alimenté par un plot d'alimentation spécifique, noté P2. Ceci permet de lui appliquer une tension d'alimentation logique spécifique, Vspec, de niveau supérieur à la tension d'alimentation logique principale du circuit. Ainsi, on pourra par exemple appliquer Vspec = 5 volts sur le plot d'alimentation P2, alors que le reste du circuit sera alimenté en Vcc = 2 volts appliqué sur le plot d'alimentation P1.

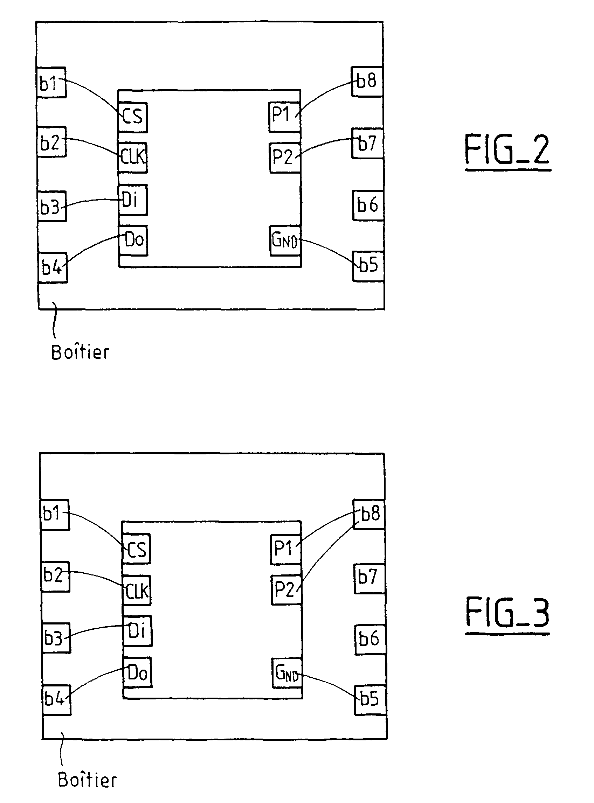

En pratique, et comme représenté sur les figures 2 et 3, on peut soit relier chacun de ces plots d'alimentation P1, P2 à une broche différente du boîtier, dans l'exemple, respectivement b8, b7 (figure 2), soit relier ces deux plots d'alimentation P1, P2 du circuit intégré à la même broche b8 du boîtier (figure 3). Il faut ici préciser que l'on entend par "plots", les zones de contacts prévues sur la puce de circuit intégré et par "broches", les pattes du boîtier dans lequel la puce est assemblée.

La première configuration représentée à la figure 2 est la plus intéressante en terme de possibilités : elle permet en effet d'appliquer une tension d'alimentation logique spécifique à la fois dans toutes les phases de test du circuit et en mode applicatif : l'utilisateur du circuit peut alors bénéficier des meilleures performances, que ce soit en terme de vitesse, de souplesse d'accès (modes globaux) et de fiabilité de la programmation des cellules. Cette configuration suppose cependant de raccorder obligatoirement la broche spécifique du boîtier à une source de tension logique. Si on entend bénéficier de ces performances et des modes d'accès globaux en applicatif, il faudra appliquer sur la broche b7 du boîtier, la tension d'alimentation logique spécifique Vspec.

Si dans l'application, on n'a pas besoin de ces performances ni des modes d'accès globaux, on devra raccorder cette broche b7 à la source d'alimentation principale (basse tension).

Dans l'autre configuration représentée à la figure 3, dans laquelle les deux plots d'alimentation P1 et P2 sont reliés à la même broche b8 d'alimentation logique principale (Vcc), le principe de l'invention ne peut être utilisé que lors du test des plaquettes (wafer test), avant assemblage dans le boîtier. Une fois la puce assemblée dans le boîtier, l'ensemble du circuit intégré, sans exception, est alimenté par la tension d'alimentation logique principale.

L'invention s'applique à tous les circuits intégrés à mémoire comprenant un circuit de génération de haute tension et alimenté en basse tension logique inférieure à 5 volts. Il permet d'améliorer le temps dédié au test du circuit intégré. Dans certains cas (figure 2), il permet d'améliorer les performances (vitesse, fiabilité de la programmation) du circuit intégré dans son application.

## Revendications

1. Circuit intégré à mémoire comprenant un circuit interne de génération d'une haute tension de programmation et comportant un premier plot (P1) destiné à recevoir une tension d'alimentation logique principale (Vcc) inférieure à cinq volts, caractérisé en ce qu'il comprend un deuxième plot d'alimentation spécifique (P2) pour alimenter ledit circuit de génération de haute tension, permettant l'application d'une tension d'alimentation logique spécifique (Vspec) de niveau de tension supérieur à celui de la tension d'alimentation logique principale.

2. Circuit intégré selon la revendication 1, caractérisé en ce que le premier plot (P1) et le deuxième plot (P2) sont chacun reliés à une broche externe différente (b8,b7) d'un boîtier.

3. Circuit intégré selon la revendication 1, caractérisé en ce que le premier plot (P1) et le deuxième plot (P2) sont reliés à une même broche (b8) d'un boîtier.

4. Utilisation d'un circuit intégré selon la revendication 1, caractérisée en ce qu'en mode de test de la puce du circuit intégré, on applique la tension d'alimentation logique spécifique (Vspec) sur le deuxième plot (P2) au moyen d'une carte à pointes.

5. Utilisation d'un circuit intégré selon la revendication 2 ou 3, caractérisé en ce qu'en phase de test final du circuit intégré assemblé dans un boîtier et en mode applicatif de ce circuit intégré, on applique sur la broche spécifique (b7) associée au deuxième plot (P2), soit la tension d'alimentation logique spécifique (Vspec), soit la tension d'alimentation logique principale (Vcc).

## Patentansprüche

1. Integrierter Speicherschaltkreis mit einem internen Hochspannungsgeneratorschaltkreis für die Programmierung und einem ersten Anschluß (P1) zum Anlegen einer Logik-Versorgungshauptspannung (Vcc) von weniger als 5 V,
dadurch gekennzeichnet, daß
er einen zweiten speziellen Versorgungsanschluß (P2) für das Versorgen des Hochspannungsgeneratorschaltkreises aufweist, so daß das Anlegen einer speziellen Logik-Versorgungsspannung (Vspec) mit einem Spannungspegel, der größer als der der Logik-Versorgungshauptspannung ist, möglich wird.

2. Integrierter Speicherschaltkreis nach Anspruch 1, dadurch gekennzeichnet, daß der erste Anschluß (Pl) und der zweite Anschluß (P2) jeweils mit einem unterschiedlichen externen Pin (b8, b7) eines Gehäuses verbunden sind.

3. Integrierter Speicherschaltkreis nach Anspruch 1, dadurch gekennzeichnet, daß der erste Anschluß (P1) und der zweite Anschluß (P2) mit einem gleichen Pin (b8) eines Gehäuses verbunden sind.

4. Verwendung eines integrierten Schaltkreises nach Anspruch 1, dadurch gekennzeichnet, daß im Testmode des Chips des integrierten Schaltkreises die spezielle Logik-Versorgungsspannung (Vspec) an den zweiten Anschluß (P2) mittels einer Spitzen-Karte angelegt wird.

5. Verwendung eines integrierten Schaltkreises nach Anspruch 2 oder 3, dadurch gekennzeichnet, daß in der Testendphase des in ein Gehäuse eingebauten integrierten Schaltkreises und in dem Anwendungsmode dieses integrierten Schaltkreises an den speziellen Pin (b7) für den zweiten Anschluß (P2) entweder die spezifische Logik-Versorgungsspannung (Vspec) oder die Logik-Versorgungshauptspannung (Vcc) angelegt wird.

## Claims

1. Integrated circuit with memory comprising an internal circuit for generating a high programming voltage and having a first pad (P1) intended to receive a main logic supply voltage (Vcc) of less than five volts, characterised in that it comprises a second specific supply pad (P2) for supplying the said high voltage generating circuit, allowing the application of a specific logic supply voltage (Vspec) with a voltage level higher than that of the main logic supply voltage.

2. Integrated circuit according to Claim 1, characterised in that the first pad (P1) and the second pad (P2) are each connected to a different external pin (b8, b7) of a case.

3. Integrated circuit according to Claim 1, characterised in that the first pad (P1) and the second pad (P2) are connected to the same pin (b8) of a case.

4. Use of an integrated circuit according to Claim 1, characterised in that, in the integrated circuit chip test mode, the specific logic supply voltage (Vspec) is applied to the second pad (P2) by means of a bed of nails.

5. Use of an integrated circuit according to Claim 2 or 3, characterised in that, in the final phase of testing the integrated circuit assembled in a case and in the application mode of this integrated circuit, there is applied to the specific pin (b7) associated with the second pad (P2) either the specific logic supply voltage (Vspec) or the main logic supply voltage (Vcc).
